# EUROPEAN PATENT APPLICATION

(11) **EP 4 459 302 A1**
(43) Date of publication of application: **06.11.2024**
(21) Application number: 24168333.3
(22) Date of filing: 03.04.2024
(51) Int. Cl.: G01R 31/392

(54) **METHOD AND DEVICE FOR DETERMINING AN ABNORMALITY IN A BATTERY**

(30) Priority: 26.04.2023 KR 20230054955
(71) Applicant: SK On Co., Ltd., Seoul 03161 (KR)
(72) Inventor: HWANG, Kyu Min, Daejeon 34124 (KR); GO, Myeong Jae, Daejeon 34124 (KR); LEE, Hyun Jun, Daejeon 34124 (KR)
(74) Representative: Prüfer & Partner mbB Patentanwälte · Rechtsanwälte

(57) **Abstract**

According to various embodiments, an operation method for determining an abnormality in a battery, the method comprising: acquiring battery information including a representative SOC value of the battery at a specific time point and a parameter value for an equivalent model circuit of the battery; acquiring an OCV deviation tolerance for the battery at the specific time point, predicting a polarization voltage deviation, and measuring a measured voltage deviation based on the battery information; and determining whether the battery is abnormal based on a sum of the OCV deviation tolerance and the polarization voltage deviation, and the measured voltage deviation, and a device thereof may be provided.

## Description

### [BACKGROUND OF THE INVENTION]

### 1. Field of the Invention

The present disclosure relates to a method and a device for determining an abnormality in a battery.

### 2. Background

In general, an electric vehicle is a vehicle which generates propulsion by driving a motor using the electrical energy stored in a battery. Because the dynamic performance of this vehicle is very closely related to the performance of the battery, it is desirable to efficiently monitor and manage the state of the battery.

### [SUMMARY OF THE INVENTION]

According to various embodiments, it is an object of the present disclosure to provide devices, systems, and methods capable of accurately determining whether a battery is abnormal depending on the state of the battery in a vehicle.

Problems to be solved through various embodiments are not limited to those expressly described herein, and other problems not described herein will be clearly understood by those skilled in the art from the following description.

In one aspect, a device for determining an abnormality in a battery based on voltage deviation, includes: a sensing unit configured to measure a voltage of the battery; an information acquisition unit configured to acquire battery information including a representative state of charge (SOC) value at a first time point and a parameter value for an equivalent model circuit of the battery; an OCV deviation determination unit configured to acquire an open circuit voltage (OCV) deviation tolerance for the battery based on the representative SOC value at the first time point; a polarization voltage deviation prediction unit configured to predict an polarization voltage deviation tolerance for the battery based on the parameter value at the first time point; a measured voltage deviation measurement unit configured to measure a measured voltage deviation for the battery at the first time point through the sensing unit; and a battery state determination unit configured to determine whether the battery is abnormal based on a sum of the OCV deviation tolerance and the polarization voltage deviation tolerance, and the measured voltage deviation.

According to an embodiment, the device may further include a storage unit in which an SOC-OCV table is stored, wherein the OCV deviation determination unit may be configured to acquire the OCV deviation tolerance for the battery by acquiring a maximum OCV value and a minimum OCV value corresponding to a result obtained by applying a preset SOC deviation to the representative SOC value based on the SOC-OCV table, and determining a difference value between the maximum OCV value and the minimum OCV value.

According to an embodiment, the device may further include a storage unit in which an equivalent model circuit corresponding to the battery is stored, wherein the polarization voltage deviation prediction unit is configured to predict the polarization voltage tolerance for the battery by determining a polarization voltage for the battery at the first time point based on the equivalent model circuit to which the parameter value is applied, and applying a preset polarization voltage deviation ratio to the polarization voltage for the battery at the first time point.

According to an embodiment, the measured voltage deviation measurement unit is configured to measure the measured voltage deviation for the battery measuring a maximum measured voltage value and a minimum measured voltage value for the circuit at the first time point, and calculating a difference value between the maximum measured voltage value and the minimum measured voltage value as the measured voltage deviation at the first time point.

According to an embodiment, the battery state determination unit is configured to determine whether the battery is abnormal by determining a voltage deviation tolerance at the first time point as a sum of the OCV deviation tolerance at the first time point and the polarization voltage deviation tolerance at the first time point, and determining whether the measured voltage deviation exceeds the voltage deviation tolerance. If the measured voltage deviation exceeds the voltage deviation tolerance, the battery is in an abnormal state.

According to an embodiment, the device may further include a storage unit in which a cumulative mileage of a vehicle including the battery is stored, wherein the OCV deviation determination unit is configured to acquire the OCV deviation tolerance based on the cumulative mileage value of the vehicle at the first time point acquired from the storage unit and the representative SOC value at the first time point.

According to an embodiment, the device may further include a storage unit in which a cumulative mileage of a vehicle including the battery is stored, wherein the sensing unit is configured to measure a temperature of the battery, and the polarization voltage deviation prediction unit is configured to determine the polarization voltage deviation tolerance based on two or more of: a cumulative mileage value of the vehicle at the first time point acquired from the storage unit, a temperature value of the battery measured at the first time point, and the parameter value at the first time point.

According to another aspect of the present disclosure, there is provided a method for determining an abnormality in a battery based on voltage deviation. The method includes acquiring battery information including a representative state of charge (SOC) value of the battery at a first time point and a parameter value for an equivalent model circuit of the battery; acquiring an OCV deviation tolerance for the battery at the first time point, predicting a polarization voltage deviation based on the battery information, measuring a measured voltage deviation based on the battery information, and determining whether the battery is abnormal based on a sum of the OCV deviation tolerance and the polarization voltage deviation, and the measured voltage deviation.

According to an embodiment, acquiring the OCV deviation tolerance includes acquiring a maximum OCV value and a minimum OCV value corresponding to a result obtained by applying a preset SOC deviation to the representative SOC value based on an SOC-OCV table; and determining a difference in value between the maximum OCV value and the minimum OCV value.

According to an embodiment, predicting the polarization voltage deviation includes determining a polarization voltage for the battery at the first time point based on the equivalent model circuit to which the parameter value is applied and applying a preset polarization voltage deviation ratio to the polarization voltage for the battery at the first time point.

According to an embodiment, measuring the measured voltage deviation includes measuring a maximum measured voltage value and a minimum measured voltage value for the circuit at the first time point, and calculating a difference value between the maximum measured voltage value and the minimum measured voltage value.

According to an embodiment, determining whether the battery is abnormal includes determining a voltage deviation tolerance at the first time point as a sum of the OCV deviation tolerance at the first time point and the polarization voltage deviation tolerance at the first time point, and determining whether the measured voltage deviation exceeds the voltage deviation tolerance.

According to an embodiment, acquiring the OCV deviation tolerance includes acquiring the OCV deviation tolerance based on a cumulative mileage value acquired from a vehicle including the battery and the representative SOC value at the first time point.

According to an embodiment, the step of measuring the measured voltage deviation may include determining the polarization voltage deviation tolerance based on two or more of: a cumulative mileage value acquired from a vehicle including the battery at the first time point, a temperature value of the battery measured at the first time point, and the parameter value at the first time point.

In another aspect, a processor is provided. The processor comprises an information acquisition unit configured to acquire battery information of a battery including a representative state of charge (SOC) value and a parameter value for an equivalent model circuit of the battery, at a first time point, an open circuit voltage (OCV) deviation determination unit configured to acquire an OCV deviation tolerance for the battery based on the representative SOC value at the first time point, a polarization voltage deviation prediction unit configured to predict a polarization voltage deviation tolerance for the battery based on the parameter value at the first time point, a measured voltage deviation measurement unit configured to measure a measured voltage deviation for the battery at the first time point through the sensing unit, and a battery state determination unit configured to determine whether the battery is abnormal based on a sum of the OCV deviation tolerance and the polarization voltage deviation tolerance, and the measured voltage deviation.

According to an embodiment, the OCV deviation determination unit is configured to acquire the OCV deviation tolerance for the battery by acquiring a maximum OCV value and a minimum OCV value corresponding to a result obtained by applying a preset SOC deviation to the representative SOC value based on an SOC-OCV table, and determining a difference in value between the maximum OCV value and the minimum OCV value.

According to an embodiment, the polarization voltage deviation prediction unit is configured to predict the polarization voltage tolerance for the battery by determining a polarization voltage for the battery at the first time point based on the equivalent model circuit, and applying a preset polarization voltage deviation ratio to the polarization voltage for the battery at the first time point.

According to an embodiment, the measured voltage deviation measurement unit is configured to measure the measured voltage deviation for the battery by measuring a maximum measured voltage value and a minimum measured voltage value for the circuit at the first time point and calculating a difference value between the maximum measured voltage value and the minimum measured voltage value.

According to an embodiment, the battery state determination unit is configured to determine whether the battery is abnormal by determining a voltage deviation tolerance at the first time point as a sum of the OCV deviation tolerance at the first time point and the polarization voltage deviation tolerance at the first time point, and determining whether the measured voltage deviation exceeds the voltage deviation tolerance.

According to an embodiment, the processor is configured to connect to a storage unit, a sensing unit, and a communication unit.

According to various embodiments, the reference for determining the state of the battery may be accurately set depending on the condition of the battery by acquiring the voltage deviation tolerance and the measured voltage deviation at each time point of determining the state of the battery.

According to various embodiments, the state of the battery may be accurately confirmed by determining the state of the battery using the voltage deviation tolerance and the measured voltage deviation which are acquired at each time point of determining the state of the battery.

### [BRIEF DESCRIPTION OF THE DRAWINGS]

The above and other objects, features and other advantages of the present invention will be more clearly understood from the following detailed description taken in conjunction with the accompanying drawings.
FIG. 1 is a schematic diagram depicting the configuration of a device according to an embodiment.
FIG. 2 is a schematic diagram depicting a connection relationship between components of a device according to an embodiment.
FIG. 3 is a schematic diagram depicting a processing unit for determining a state of a battery according to an embodiment.
FIG. 4 is a flowchart depicting procedures of a method of determining the state of a battery according to an embodiment.
FIG. 5 is a diagram depicting a portion of an OCV-SOC table for determining corresponding SOC values based on OCV values measured in a device according to an embodiment.
FIG. 6 is a circuit diagram depicting a portion of an equivalent model circuit of a battery in the device according to an embodiment.
FIG. 7 is a graph depicting the voltage, current, and SOC of the battery acquired at various time points in a device according to an embodiment.
FIG. 8 is a graph depicting a OCV deviation tolerance, polarization voltage deviation tolerance, and voltage deviation tolerance of the battery acquired at various time points by a device according to an embodiment.
FIG. 9 is a graph depicting a battery voltage deviation tolerance and measured voltage deviation acquired at various time points by a device according to an embodiment.

### [DETAILED DESCRIPTION OF THE INVENTION]

As described above, efficient monitoring and management of the state of a electric vehicle battery may improve performance of the battery. The battery is generally composed of a plurality of cells. In order to ensure safety, improve life-span, and obtain high output, it is desirable for the plurality of cells to uniformly adjust voltages of the respective cells.

For this purpose, the battery for a vehicle is may be by a controller collectively referred to as a battery management system (BMS). The battery management system can collect various information (such as a battery voltage, battery current, battery temperature, etc.) for battery management from the battery, and calculate various parameters for battery management by applying various pre-determined algorithms to the collected information.

In certain instances, battery management techniques may be performed in a state where power is being supplied to the battery management system, that is, in a power-on (IG ON) state. In other words, the state of the battery is monitored in a state where a main relay connected to the battery forms an electrical connection between other components of the vehicle (for example, a power module that converts power from the battery and provides it to the motor, or a charger that generates power to charge the battery, etc.) and the battery. Thus, in these systems, the vehicle uses battery information that is collected while the battery and other components are electrically connected, Consequently, the determination of the battery state is performed based on the established reference without actually reflecting such state of the battery. Therefore, it may be difficult to accurately determine the state of the battery.

Hereinafter, embodiments will be described in detail with reference to the accompanying drawings. However, since various changes may be made in the embodiments, the scope of the patent invention is not limited or restricted by these embodiments.

The terms used in the embodiments are used only for the purpose of describing the invention, and should not be interpreted as limiting. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements, and/or components, but do not preclude the presence or addition of one or more other features, integers, steps, operations, elements, components, and/or combinations thereof.

Unless otherwise defined, all terms including technical or scientific terms used herein have the same meaning as commonly understood by one of ordinary skill in the art to which the present invention pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Further, in describing the embodiments with reference to the accompanying drawings, the same reference numerals are denoted to the same components regardless of the number of the drawings, and the same configuration will not be repeatedly described. Further, in description of the embodiments, the publicly known techniques related to the present invention, which are verified to be able to make the purport of the present invention unnecessarily obscure, will not be described in detail.

In addition, in describing components of the embodiment, the terms such as first, second, A, B, (a), (b), and the like may be used. These terms are intended to divide the components from other components, and do not limit the nature, sequence or order of the components.

It will be understood that when a component is described to as being "connected," "combined" or "coupled" to another component, the component may be directly connected or coupled the another component, but it may be "connected," "combined" or "coupled" to the another component intervening another component may be present.

In addition, it will be understood that when a component is described as being "connected" or "combined" by communication to another component, that component may be connected or combined by wireless or wired communication to the another component, but it may be "connected" or "combined" to the another component intervening another component may be present.

Components included in an embodiment and components including common functions will be described using the same names in other embodiments. The description given in an embodiment may be applied to other embodiments, and therefore will not be described in detail within the overlapping range, unless there is a description opposite thereto.

The device and/or 'data' processed by the device may be expressed in terms of 'information.' Here, the information may be used as a concept including the data.

In various embodiments, a method and a device for determining an abnormality in a battery based on the voltage deviation acquired at a time point of determining the battery state will be described. To describe in more detail, a method for determining the state the battery using a reference value generated at the time point of determining the battery state in a way of acquiring a representative SOC value of the battery at the time point of determining an abnormality in the battery, and determining the reference value for determining the state of the battery based on the acquired value, and a device for implementing the method will be described.

To this end, a device 100 is a device for battery management, and may be configured as a battery management system (BMS) or a portion thereof. Hereinafter, embodiments will be described with reference to the accompanying drawings. It is noted that while the drawings attached to the present specification serve to further understand the technical idea together with the detailed description, such that the present disclosure should not be construed as being limited only to the illustrations of the drawings.

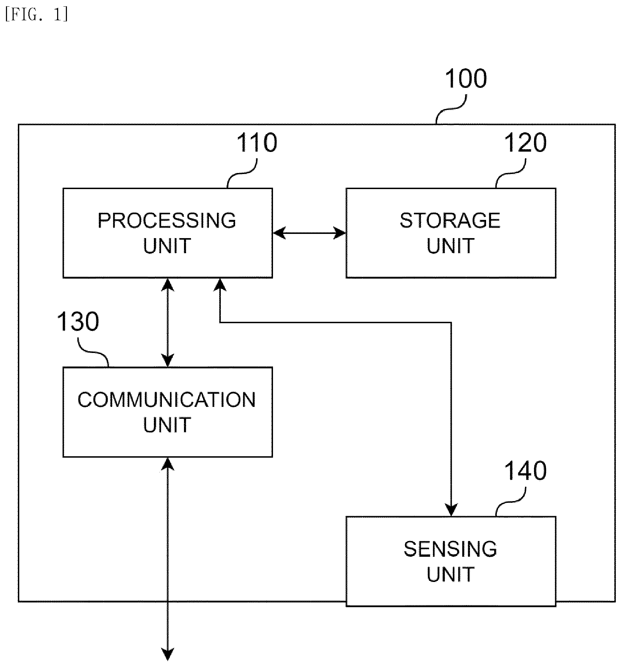

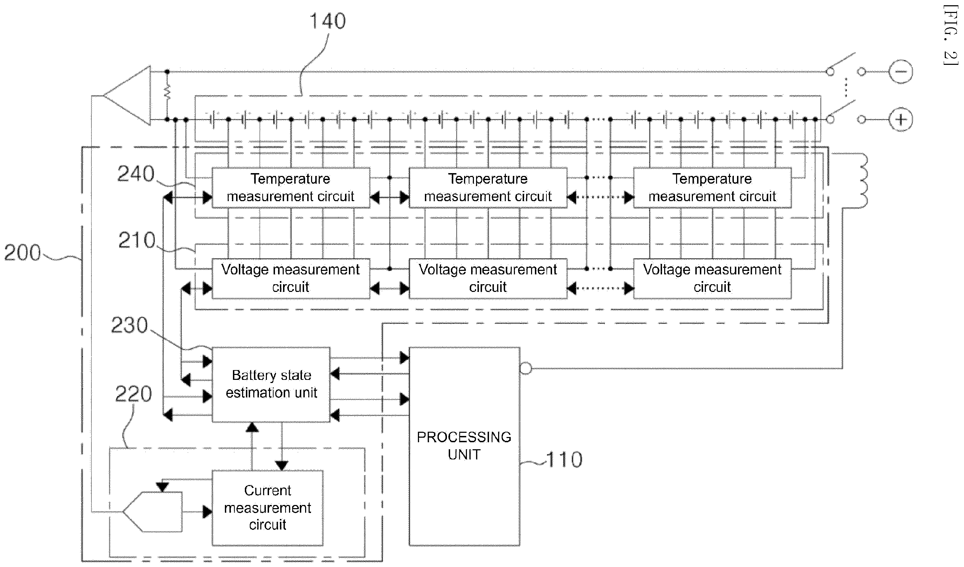

FIG. 1 is a schematic diagram depicting the configuration of a device according to an embodiment and FIG. 2 is a schematic diagram depicting a connection relationship between components of a device according to an embodiment.

Referring to FIGS. 1 and 2, the device 100 may include a processing unit 110, a storage unit 120, a communication unit 130, and a sensing unit 140. The processing unit 110 may be configured to connect to the storage unit 120, the communication unit 130, and/or the sensing unit 140.

The processing unit 110 includes at least one processor (or controller), and may process at least one control command related to management of at least one battery connected to the device 100 through at least one program (app, application, tool, plug-in, software, and the like, hereinafter referred to as a battery management program). In this case, the battery management program may be stored in the storage unit 120 of the device 100 or a storage unit of another device connected to the device 100.

The processing unit 110 may share data processing or processing results with at least one other device (e.g., a user device) connected to the device 100 through the battery management program.

In some embodiments, performing an operation according to the control commands by the device 100 comprises performing an operation designated through at least one program or the battery management program related to at least one control command processing of the device 100.

For example, the control command processing is performed through the at least one program or the battery management program installed in the device 100. However, embodiments described herein are not limited thereto, and control command processing may be performed through another program or a temporary installation program previously installed in the storage unit 120. As another example, the control command processing may be performed through at least a portion of a database provided free of charge or for a fee in an external device connected to the device 100.

The operation of the device 100 is performed based on the data processing and device control of the processing unit 110, and the processing unit 110 may also perform functions designated on the basis of the control commands received through an input/output unit or the communication unit of the device 100.

Further, in processing data acquired through the communication unit 130, the processing unit 110 may process the data based on an identified user. For example, the processing unit 110 may perform an operation according to the control command input by the user device connected to the device through the communication unit 130 and/or the identified user who has been identified through user information.

In an embodiment, when the device 100 may be configured as a battery management system (or a portion thereof), the processing unit 110 may be configured as the battery management unit (BMU), or may be configured to perform at least some functions of the battery management unit.

The storage unit 120 may store various data processed by at least one component (e.g., the processing unit 110 or the communication unit 130) of the device 100. The data may include, for example, a program for control command processing or data processed through the program, or input data and output data related thereto.

The storage unit 120 may include an algorithm for control command processing, which includes at least some of an artificial neural network algorithm, a blockchain algorithm, a deep learning algorithm, and a regression analysis algorithm, as well as mechanisms, operators, language models, and big data related thereto.

The storage unit 120 may include data for confirming and processing control and operations designated through signals received by each component included in the input/output unit.

The storage unit 120 may store an equivalent model circuit or an equivalent model algorithm for at least some of the circuits constituting the battery in order to simulate the state or operation of the battery. Here, the equivalent model circuit for the battery (or corresponding to the battery) (hereinafter, referred to as an equivalent model circuit) or the equivalent model algorithm may be a program designed based on a digital twin.

The operations described through the storage unit 120 may be processed by the processing unit 110, and data for processing the related operations, data in process, processed data, preset data, and the like may be stored in the storage unit 120 as a database.

The data stored in the storage unit 120 may be changed, modified, deleted, or generated as new data by the processing unit 110 based on user input of the identified user.

The storage unit 120 may store device setting information of the device 100. The device setting information may be setting information on the device 100 and at least some of functions and services provided by the device 100.

The storage unit 120 may store user information (or user account information) for at least one user.

The storage unit 120 may include a volatile memory, a non-volatile memory, and/or a computer-readable recording medium as known in the art. In this case, the computer-readable recording medium may store a computer program for performing an operation to determine an abnormality in circuits of the battery by the device 100 based on various embodiments.

The communication unit 130 may support establishment of a wired communication channel or establishment of a wireless communication channel between the device 100 and at least one other device (e.g., the user device or a server). The communication unit 130 may further support performing communication through the established communication channel.

The communication unit 130 may perform operations such as modulation/demodulation and encryption/decryption, etc., during performing communication. The modulation/demodulation and encryption/decryption may comprise any methods of modulating/demodulating and encrypting/decrypting known to those in the art.

The communication unit 130 may be operated dependently on, or independently from, the processing unit 110, and may include one or more communication processors which support wireless communication and/or wired communication.

According to an embodiment, when supporting wireless communication, the communication unit 130 may include one or more wireless communication modules, for example, a cellular communication module, a near field communication module, and a global navigation satellite system (GNSS) communication module.

When supporting wired communication, the communication unit 130 may include one or more wired communication modules, for example, a local area network (LAN) communication module, a power line communication module, a controller area network (CAN) communication module, and a serial peripheral interface (SPI).

To describe in more detail, the communication unit 130 may communicate with an external device by wired and/or wirelessly through near field communication networks such as Bluetooth, Bluetooth Low Energy (BLE), WiFi, WiFi direct, Infrared Data Association (IrDA), ZigBee, UWB, and radio frequency (RF), or far field communication networks such as a cellular network, the Internet or a computer network (e.g., LAN or WAN).

Various types of communication modules constituting the communication unit 130 may be integrated into one component (e.g., a single chip), or may be implemented as a plurality of separate components (e.g., a plurality of chips).

As shown in FIG. 1, the communication unit 130 may communicate with an external device of the device 100, but it is not limited thereto, and for example, may communicate with at least some of the internal components of device 100, such as the storage unit 120, the sensing unit 140 and the like.

The sensing unit 140 may monitor the state of the battery included in the device 100. The configuration of the sensing unit 140 is described in greater detail below with respect to FIG. 2.

As shown in FIG. 2, the sensing unit 140 may include one or more of: a voltage management unit 210 configured to measure and manage a voltage of the battery; a current management unit 220 configured to measure and manage a current of the battery; a battery state estimation unit 230 configured to estimate a state of the battery based on information received from the voltage management unit 210 or the current management unit 220; and a temperature measurement circuit 240 configured to measure a temperature of the battery based on a temperature sensor.

The voltage management unit 210 may include at least one voltage measurement circuit configured to measure the voltage of the battery (or cells). Here, the sensing unit 140 including the voltage management unit 210, or the voltage management unit 210 itself, may include at least one processor or controller.

The current management unit 220 may configured to measure the current of the battery. To describe in more detail, the current management unit 220 may include at least one current measurement circuit configured to measure the current of the battery. In addition, the current management unit 220 may perform operations of detecting an overcurrent or monitoring an insulation state of the battery. In addition, the current management unit 220 may monitor or control the state of a contactor (e.g., a switch) of the battery.

Here, the operation of the current management unit 220 may be performed according to control commands received from the processing unit 110. However, the current management unit 220 may perform operations of measuring the current, detecting the overcurrent, or monitoring insulation state of the battery independently of the operation of the processing unit 110, or may monitor or control the state of the contactor in the battery.

In some embodiments, the sensing unit 140 including the current management unit 220, or the current management unit 220 itself, may include at least one processor or controller.

According to an embodiment, the voltage management unit 210 may be configured as a cell monitoring unit (CMU) or may be configured to perform at least some of the functions of the cell monitoring unit. In addition, the current management unit 220 may be configured as a battery junction box (BJB), or may be configured to perform at least some of the functions of the battery junction box.

The battery state estimation unit 230 may receive the measured voltage of the battery and information related to the battery voltage from the voltage management unit 210. In addition, the battery state estimation unit 230 may receive the measured current of the battery and information related to the battery current from the current management unit 220. In addition, the battery state estimation unit 230 may receive the measured temperature of the battery and information related to the battery temperature from the temperature measurement circuit 240.

The battery state estimation unit 230 may estimate the battery state based on the information received from the voltage management unit 210, the current management unit 220, or the temperature measurement circuit 240. For example, the battery state estimation unit 230 may estimate information related to damage or life-span for each cell.

The battery state estimation unit 230 may transmit designated information related to the battery to the processing unit 110 based on a request from the processing unit 110. In some embodiments, the voltage management unit 210, the current management unit 220, and the battery state estimation unit 230 are separate modules. However, embodiments described herein are not limited thereto, and two or more modules may be included in a single module.

According to various embodiments, the device 100 may be connected to the battery to be monitored. The battery may includes at least one cell, and the battery may be prepared in the form of a battery pack or a battery module. For example, the battery module may include two or more cells, and the battery pack may include at least one battery module. The battery may be connected to the components of the device 100 outside of the device 100 through a power supply unit (not shown) of the device 100 or the communication unit 130. However, embodiments are not limited thereto, and the battery may be located inside of the device 100. In such a case, the battery may be configured to be attachable to/detachable from the device 100.

According to various embodiments, the device 100 or the user device may include at least some of the functions of all information and communication devices including a mobile communication terminal, a multimedia terminal, a wired terminal, a fixed terminal, an internet protocol (IP) terminal and the like.

The device 100 may be a device for control command processing, and may include at least some functions of a workstation or a large-capacity database, or may be connected thereto through communication.

As the user device connected to the device 100, a mobile phone, a personal computer (PC), a portable multimedia player (PMP), a mobile internet device (MID), a smartphone, a tablet PC, a phablet PC, a laptop computer, and the like may be exemplified.

According to various embodiments, the user device may be a device which is connected to the device 100 and communicates therewith. For example, although not illustrated throughout the drawings, the user device may be a smartphone of the user, which is connected to the device 100 through wireless communication and transmits user input to generate charge settings information by the device 100.

The user device may be connected to the device 100 through at least one program installed therein, or may be connected to the device 100 through at least one web page accessed on online by the device 100. In some embodiments, the device 100 may include at least some of the functions of a server, or a kiosk for providing a charging control service.

The server may be an entity that exists on a network, and performs roles of a web server, a database server, and an application server. According to an embodiment, the server may provide various services to the device 100 or the user device based on processing of the device 100.

As described above, the device 100 may be configured as a battery management system which manages battery 200 or a portion thereof, and may determine an abnormality in the battery 200 based on a representative SOC value acquired at the time point of determining the state of the battery.

The operation of device 100 to determine the state of the battery is described in greater detail below with reference to the drawings.

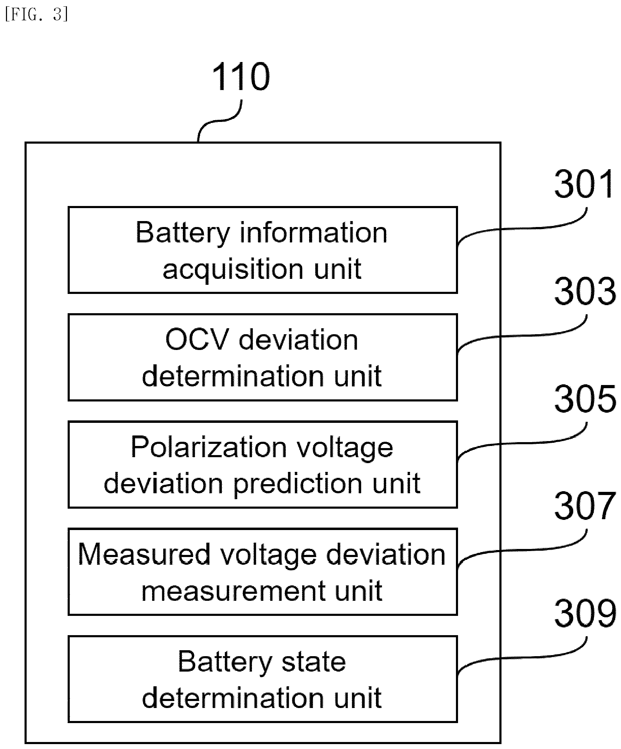

FIG. 3 is a schematic diagram depicting a processing unit for determining a state of a battery according to an embodiment. In an embodiment, the processing unit 110 may include a battery information acquisition unit 301, an OCV deviation determination unit 303, a polarization voltage deviation prediction unit 305, a measured voltage deviation measurement unit 307, and a battery state determination unit 309.

The battery information acquisition unit 301 may receive representative state of charge (SOC) values for the battery from the voltage management unit 210 at a designated time interval or in real time.

In addition, the battery information acquisition unit 301 may receive measured parameter values for at least some of parameters for operation of the equivalent model circuit from the voltage management unit 210 or the current management unit 220.

As described above, the battery information acquisition unit 301 may receive a representative SOC value at a specific time point from the voltage management unit 210. In another embodiment, the battery information acquisition unit 301 may receive the SOC values measured for each of the cells constituting the battery at a specific time point from the voltage management unit 210, and may then calculate the representative SOC value for the battery at the specific time point based on the received SOC values and a preset representative SOC calculation algorithm.

In addition, for operation of the equivalent model circuit, the battery information acquisition unit 301 may receive at least some of the OCV values for the battery or cells, close circuit voltage (CCV) values for the battery or cells, current values flowing in the battery or cells, and internal resistance values for the battery or cells at a specific time point as parameter values.

Here, a CCV value may represent the voltage between terminals of the battery or cells measured when charging or discharging the battery.

In addition, the battery information acquisition unit 301 may further acquire voltage change values for the battery or cells. These voltage change values may be based on the current values flowing through the battery or cells at a specific time point as the parameter values.

In an embodiment, when acquiring a voltage change value at a specific time point, the battery information acquisition unit 301 may acquire the voltage change values for the battery and cells based on the specific time point and at least one time point before the specific time point.

The battery information acquisition unit 301 may acquire voltage values (e.g., OCV values or CCV values) for cells by acquiring voltage values for each cell, acquiring voltage values by unit of two or more specified cells, acquiring voltage values by unit of battery module, or acquiring voltage values by unit of battery pack.

According to various embodiments, the battery information acquisition unit 301 may acquire at least some information related to the number of charging cycles or discharging cycles, charging time, discharging time, and rest time of the battery as battery information.

In addition, when the battery is included in a vehicle, the battery information acquisition unit 301 may acquire at least some information related to the driving time and mileage of the vehicle as battery information.

To describe in more detail, the battery information acquisition unit 301 may acquire at least some information related to the cumulative mileage, driving time, recent mileage, and recent driving time of the vehicle, and store them in the storage unit 120.

The OCV deviation determination unit 303 may determine an OCV deviation tolerance for the battery at a specific time point based on the representative SOC value of the battery acquired through the battery information acquisition unit 301. The specific time point may represent points along a designated time interval. For example, to determine the state of the battery at a first time point, the OCV deviation unit may make a first determination at that first time point. To determine the state of the battery at a second time point, the OCV deviation unit may make a second determination at the second time point. It is to be noted that the terms "first time point" and "second time point" do not necessarily reflect a temporal order, but reflect that there are multiple specific time points at which determinations and measurements may be made.

To determine the OCV deviation tolerance, the OCV deviation determination unit 303 may determine a maximum SOC value and a minimum SOC value by applying a preset SOC deviation to the representative SOC value. In this case, the preset SOC deviation may be a preset value, for example, a positive (+) SOC deviation value or a negative (-) SOC deviation value.

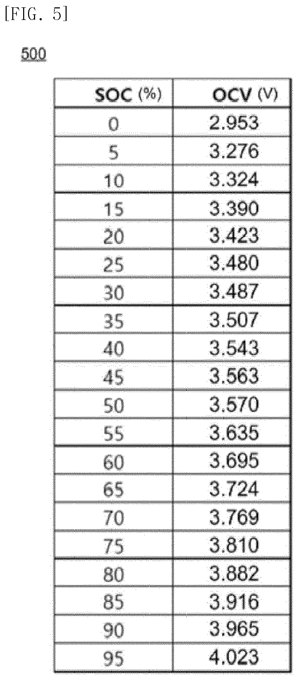

Thereafter, the OCV deviation determination unit 303 may acquire a maximum OCV value and a minimum OCV value corresponding to the maximum SOC value and minimum SOC value, respectively, based on an OCV-SOC table (or an SOC-OCV table). Such a table is described in greater detail below with reference to FIG. 5.

FIG. 5 is a diagram depicting a portion of an OCV-SOC table for determining corresponding SOC values based on OCV values measured in a device according to an embodiment .

According to an embodiment, an OCV-SOC table 500 for cells of the battery connected to the device 100 may be stored in the storage unit 120. The OCV deviation determination unit 303 may acquire SOC values corresponding to specific OCV values for each cell based on the OCV-SOC table 500, or acquire OCV values corresponding to the specific SOC values.

In an embodiment, the OCV-SOC table 500 stored in the storage unit 120 may include OCVs corresponding to the SOC values by 5% unit for SOC values from 0% to 100%. However, it is not limited thereto, and the OCV-SOC table 500 may be an OCV-SOC table to which a specific value as a unit depending on settings such as 1% unit, 0.1% unit, or the like is applied.

Additionally, the OCV value corresponding to each SOC value may describing a particular embodiment, and at least some of the OCV values corresponding to the SOC values of the OCV-SOC table 500 may be reset by the device 100 or by the user based on the values measured when (or after) charging or discharging the battery.

Returning to FIG. 3, the OCV deviation determination unit 303 may acquire a maximum OCV value and a minimum OCV value corresponding to the maximum SOC value and minimum SOC value, respectively, based on the OCV-SOC table.

According to various embodiments, the OCV deviation determination unit 303 may acquire the OCV deviation tolerance based on the cumulative mileage value and representative SOC values of the vehicle.

To describe in more detail, when performing an operation of acquiring an OCV deviation tolerance at a specific time point, the OCV deviation determination unit 303 may determine a SOC correction value based on the cumulative mileage value of the vehicle, and reflect the SOC correction value in the representative SOC value. The OCV determination unit 303 may then acquire the OCV deviation tolerance based on the corrected SOC value.

In this case, a mileage-SOC correction value table in which the SOC correction values corresponding to at least one cumulative mileage value are preset may be stored in the storage unit 120, or a calculation formula (first calculation formula) for linearly calculating the SOC correction value (%) based on a preset coefficient for a unit mileage (e.g., 1 km). In such an embodiment, the calculation formula may also be stored in the storage unit 120.

For example, when the first calculation formula is stored in the storage unit 120, it may be assumed a state where the first calculation formula is composed of a linear equation that outputs the SOC correction value (%) for an input value of the cumulative mileage (km), and the preset coefficient (%/km) for the unit mileage is set to be 0.00004.

In this case, when a vehicle' s cumulative mileage value of 150,000 km is acquired from the storage unit 120 at a specific time point, the OCV deviation determination unit 303 may determine a SOC correction value of 6% for the acquired cumulative mileage value.

The OCV deviation determination unit 303 may apply (e.g., add) a correction value of 6% to the representative SOC value acquired at the specific time point, and determine an OCV deviation tolerance based on the representative SOC value to which the correction value is applied.

In another example, a vehicle' s cumulative mileage value of 300,000 km may be acquired from the storage unit 120 at a specific time point, and the OCV deviation determination unit 303 may determine an SOC correction value of 12% for the acquired cumulative mileage value.

The OCV deviation determination unit 303 may apply (e.g., add) a correction value of 12% to the representative SOC value acquired at the specific time point, and determine an OCV deviation tolerance based on the representative SOC value to which the correction value is applied.

Here, the first calculation formula for calculating the SOC correction value (%) and the preset coefficient for the unit mileage constituting the first calculation formula may be altered or otherwise changed by the OCV deviation determination unit 303, or by user input.

In an embodiment, the polarization voltage deviation prediction unit 305 may determine a polarization voltage deviation tolerance for the battery at a specific time point based on at least one parameter value and an equivalent model circuit acquired at time points including the specific time point through the battery information acquisition unit 301.

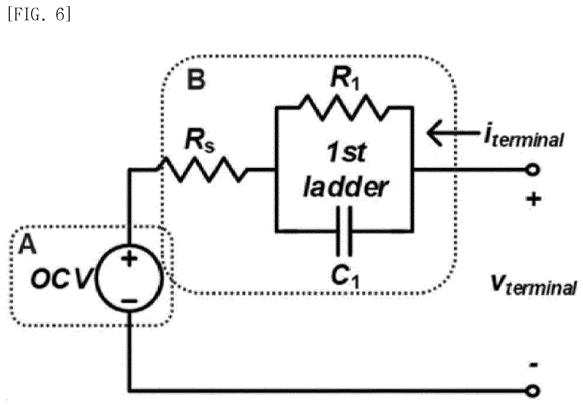

To enable this determination, the device 100 may include the equivalent model circuit and the equivalent model algorithm. FIG. 6 FIG. 6 is a circuit diagram depicting a portion of an equivalent model circuit of a battery in the device according to an embodiment.

Referring to FIG. 6, the polarization voltage deviation prediction unit 305 may acquire a parameter value for driving the equivalent model circuit and determine a polarization voltage B based on the equivalent model circuit to which the acquired parameter value (e.g., the current value) is applied.

For example, the polarization voltage deviation prediction unit 305 may measure a current value (Iₜₑᵣₘᵢₙₐₗ) of the battery at a specific time point, or may acquire a current value of the battery at the specific time point based on the driving of the equivalent model circuit.

The polarization voltage deviation prediction unit 305 may acquire the polarization voltage B at the specific time point from the equivalent model circuit by driving the equivalent model circuit using the acquired parameter value (e.g., the current value, etc.) as an input value. In this case, the polarization voltage deviation prediction unit 305 may measure the polarization voltages B for each cell included in the battery based on the equivalent model circuit.

Here, when at least one parameter value at a specific time point is additionally utilized for driving the equivalent model circuit, the polarization voltage deviation prediction unit 305 may acquire the corresponding parameter (e.g., a CCV value Vₜₑᵣₘᵢₙₐₗ, or OCV value) at a specific time point, and then drive the equivalent model circuit.

For example, the polarization voltage deviation prediction unit 305 may measure a CCV value of the battery at a specific time point, or may acquire the CCV value of the battery at the specific time point based on driving of the equivalent model circuit.

In addition, the polarization voltage deviation prediction unit 305 may measure an OCV value of the battery at a specific time point, or measure an OCV value A of the battery at the specific time point based on the driving of the equivalent model circuit.

The polarization voltage deviation prediction unit 305 may determine a polarization voltage deviation tolerance value by applying a preset polarization voltage deviation to the acquired polarization voltage B.

For example, the preset polarization voltage deviation may be a preset positive (+) polarization voltage deviation value or a negative (-) polarization voltage deviation value. The polarization voltage deviation prediction unit 305 may determine a maximum polarization voltage value and a minimum polarization voltage value based on the result obtained by applying the polarization voltage deviation to the polarization voltage B, and determine the polarization voltage deviation tolerance by measuring the difference in value between the maximum polarization voltage value and the minimum polarization voltage value.

According to various embodiments, the polarization voltage deviation prediction unit 305 may acquire the polarization voltage deviation tolerance based on the cumulative mileage value and at least one parameter value of the vehicle.

In an embodiment, to acquire the polarization voltage deviation tolerance at a specific time point, the polarization voltage deviation prediction unit 305 may determine a polarization voltage correction value (a first polarization voltage correction value) based on the cumulative mileage value of the vehicle, determine a corrected polarization voltage deviation tolerance (e.g., a final polarization voltage deviation tolerance) by applying the first polarization voltage correction value to the polarization voltage deviation tolerance (e.g., a preliminary polarization voltage deviation tolerance) acquired at the specific time point.

In this case, the storage unit 120 may store a mileage-first polarization voltage correction value table or a calculation (referred to herein at points as a "second calculation formula" ). The mileage-first polarization voltage correction value table may correspond the polarization voltage correction values corresponding with least one preset cumulative mileage value. The second calculation formula may enable linearly calculating the first polarization voltage correction value (%) based on a preset coefficient for the unit mileage.

For example, when the second calculation formula is stored in the storage unit 120, it may be assumed a state where the second calculation formula is composed of a linear equation that outputs the first polarization voltage correction value (%) for an input value of the cumulative mileage value (km), and the preset coefficient (%/km) for the unit mileage is set to be 0.00014.

In this case, when a vehicle' s cumulative mileage value of 150,000 km is acquired from the storage unit 120 at a specific time point, the polarization voltage deviation prediction unit 305 may determine a first polarization voltage correction value of 21% for the acquired cumulative mileage value.

The polarization voltage deviation prediction unit 305 may determine a final polarization voltage deviation tolerance by applying (e.g., adding) the correction value of 21% to the preliminary polarization voltage deviation tolerance value acquired at the specific time point.

In another exmaple, when a vehicle' s cumulative mileage value of 300,000 km is acquired from the storage unit 120 at a specific time point, the polarization voltage deviation prediction unit 305 may determine a first polarization voltage correction value of 42% for the acquired cumulative mileage value.

The polarization voltage deviation prediction unit 305 may determine a final polarization voltage deviation tolerance by applying (e.g., adding) the correction value of 42% to the preliminary polarization voltage deviation tolerance value acquired at the specific time point.

Here, the second calculation formula for calculating the first polarization voltage correction value (%) and the preset coefficient for the unit mileage constituting the second calculation formula may be changed by the polarization voltage deviation prediction unit 305 or user input.

According to various embodiments, the polarization voltage deviation prediction unit 305 may acquire the polarization voltage deviation tolerance based on the temperature value and at least one parameter value of the battery.

In an embodiment, to acquire the polarization voltage deviation tolerance at a specific point, the polarization voltage deviation prediction unit 305 may determine a polarization voltage correction value (second polarization voltage correction value) based on the temperature value of the battery, and determine a corrected polarization voltage deviation tolerance (e.g., the final polarization voltage deviation tolerance) by applying the second polarization voltage correction value to the polarization voltage deviation tolerance (e.g., the preliminary polarization voltage deviation tolerance) acquired at the specific time point.

In this case, the storage unit 120 may store a temperature value-polarization voltage correction value table in which polarization voltage correction values corresponding to the battery temperature values are preset, or polarization voltage correction values for at least one preset temperature range.

For example, it may be assumed a state where a second polarization voltage correction value of +20% is set for the battery temperature of less than 10 degrees Celsius and 0 degrees Celsius or higher.

In this case, when a battery temperature of 9 degrees Celsius is acquired from the temperature measurement circuit 240 at a specific time point, the polarization voltage deviation prediction unit 305 may determine a second polarization voltage correction value of 20%.

The polarization voltage deviation prediction unit 305 may determine a final polarization voltage deviation tolerance by applying (e.g., adding) the correction value of 20% to the preliminary polarization voltage deviation tolerance value acquired at the specific time point.

Here, the second calculation formula for calculating the polarization voltage correction value (%) and the preset coefficient for the unit mileage constituting the second calculation formula may be changed by the polarization voltage deviation prediction unit 305 or user input.

According to various embodiments, the polarization voltage deviation prediction unit 305 may determine the final polarization voltage deviation tolerance obtained by applying the first polarization voltage correction value or the second polarization voltage correction value at the specific time point as the polarization voltage deviation tolerance at the specific time point.

In this case, when calculating the final polarization voltage deviation tolerance by applying the first polarization voltage correction value and the second polarization voltage correction value, the polarization voltage deviation prediction unit 305 may apply the first polarization voltage correction value and the second polarization voltage correction value according to the specified order, or a sum of the first polarization voltage correction value and the second polarization voltage correction value to the preliminary polarization voltage deviation tolerance.

As described above, the polarization voltage deviation prediction unit 305 may apply a preset ratio of polarization voltage deviation to the polarization voltage of the battery at the specified time point as a polarization voltage correction value to determine the polarization voltage deviation tolerance.

However, embodiments are not limited to the deviations described above, and the polarization voltage deviation may be defined as a specific preset value or may be defined in a preset range.

Returning to FIG. 3, the measured voltage deviation measurement unit 307 may measure a measured voltage deviation (CCV measurement deviation) for the battery at a specific time point. To describe in more detail, the measured voltage deviation measurement unit 307 may measure CCV values of a plurality of cells included in the battery at a specific time point and acquire the measured voltage deviation based on the measured CCV values.

In an embodiment, the measured voltage deviation measurement unit 307 may acquire a maximum CCV value and a minimum CCV value from the CCV values measured for the plurality of cells included in the battery at the specific time point. The measured voltage deviation measurement unit 307 may determine a difference value between the maximum CCV value and the minimum CCV value as the measured voltage deviation at the specific time point.

Here, the measured voltage may be a voltage across the battery measured at any time point (e.g., a specific time point) among the state of charge, state of discharge, and rest state of the battery circuit. However, embodiments are not limited thereto, and the measurement voltage may be a CCV voltage of the battery.

The battery state determination unit 309 may determine a voltage deviation tolerance at the specific time point as a sum of the OCV deviation tolerance acquired at the specific time point and the polarization voltage deviation tolerance acquired at the specific time point. In an embodiment, the battery state determination unit 309 may calculate the voltage deviation tolerance at the specific time point by summing the OCV deviation tolerance acquired at the specific time point and the polarization voltage deviation tolerance acquired at the specific time point. In other embodiments, the battery state determination unit may receive this value from other components and perform the operations described below based on this received information.

The battery state determination unit 309 may compare the voltage deviation tolerance with the measured voltage deviation acquired at the specific time point, and determine that the battery is in a "normal state" if the measured voltage deviation is less than the voltage deviation tolerance.

If, instead, the measured voltage deviation exceeds the voltage deviation tolerance as a result of the comparison, the battery state determination unit 309 may determine that the battery is in an "abnormal state (a state where a battery abnormality has occurred)."

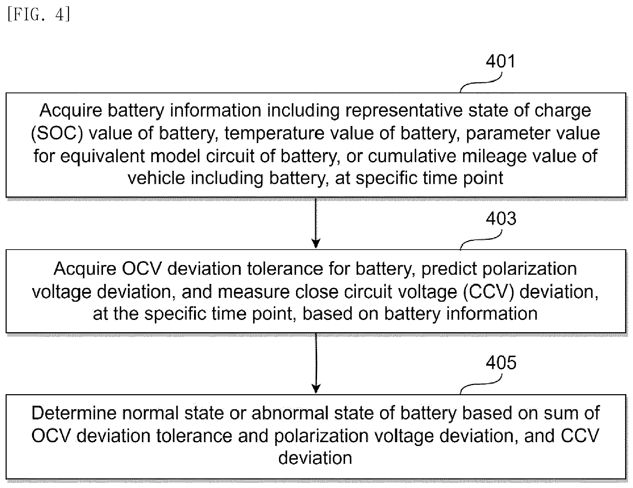

An operation for determining the state of the battery in the device 100 may is described below with reference to FIG. 3 and FIG. 4. FIG. 4 is a flowchart depicting procedures of a method of determining the state of a battery according to an embodiment.

In step 401, the device 100 may acquire battery information including at least one of a representative state of charge (SOC) value of the battery, a temperature value of the battery, and parameter values for the equivalent model circuit of the battery, at a specific time point.

In addition, when the battery is included in a vehicle, the device 100 may acquire a cumulative mileage value of the vehicle at the specific time point from the storage unit 120. For example, the battery information acquisition unit 301 may acquire battery information at a specific time point, such as at a designated time interval or in real time.

To describe in more detail, the battery information acquisition unit 301 may receive the representative SOC value for the battery at the specific time point or parameter values of the equivalent model circuit from the voltage management unit 210 or the current management unit 220.

Here, the specific time point may be one time point (or time points in a designated time unit) of the various points in time at which the battery information acquisition unit 301 acquires the battery information, and may be a time point stored in the setting information (e.g., device setting information or user setting information) or a time point selected by the user.

In step 403, the device 100 may acquire an OCV deviation tolerance for the battery, predict a polarization voltage deviation, and measure a measured voltage deviation, based on the battery information, at a specific time point.

In an embodiment, the device 100 may acquire an OCV correction value based on the acquired cumulative mileage value of the vehicle, and apply the acquired OCV correction value to the representative SOC value at the specific time point.

The OCV deviation determination unit 303 may determine a maximum SOC value and a minimum SOC value based on the representative SOC value (when the OCV correction value is applied, the corrected representative SOC value), and determine an OCV deviation tolerance based on the maximum SOC value and the minimum SOC value.

The OCV deviation determination unit 303 may determine a maximum SOC value and a minimum SOC value by applying a preset positive (+) SOC deviation value or negative (-) SOC deviation value to the representative SOC value.

As a specific example, a negative (-) SOC deviation value may be applied to an example state where the representative SOC value of the battery acquired at the specific time point is 40% and the SOC deviation is set to -15%. The OCV deviation determination unit 303 may then determine a state where the SOC value of 40% is the maximum SOC value, and a state where the SOC value is 25% as the minimum SOC value.

In another specific, example, a positive (+) SOC deviation value may be app[lied to an example state where the representative SOC value of the battery acquired at the specific time point is 40% and the SOC deviation set to +5%. The OCV deviation determination unit 303 may then determine a state where the SOC value is 45% as the maximum SOC value, and a state where the SOC value is 40% may be determined as the minimum SOC value.

In another specific example, both a negative (-) SOC deviation value and the positive (+) SOC deviation value may be applied. In this example, the deviations may be applied to a state where the representative SOC value of the battery acquired at the specific time point is 40% with the SOC deviations set to -15% and +5%. The OCV deviation determination unit 303 may then determine a state where the SOC value is 25% as the minimum SOC value, and a state where the SOC value is 45% as the maximum SOC value.

From these values, the OCV deviation determination unit 303 may acquire a maximum OCV value and a minimum OCV value corresponding to the maximum SOC value and minimum SOC value, respectively, based on the OCV-SOC table (or the SOC-OCV table).

For example, as described above, in the case where the maximum SOC value of 40% and the minimum SOC value of 25% are acquired, when referring to the OCV-SOC table 500, the OCV deviation determination unit 303 may acquire a maximum OCV value of 3.543V and a minimum OCV value of 3.480V.

Thereafter, the OCV deviation determination unit 303 may determine a difference value between the maximum OCV value and the minimum OCV value as the OCV deviation tolerance (value) at the specific time point.

For example, as described above, when the maximum OCV value of 3.543V and the minimum OCV value of 3.480V are acquired, the OCV deviation determination unit 303 may determine 0.063V, which is a difference value between the maximum OCV value and the minimum OCV value, as the OCV deviation tolerance value.

In addition, the polarization voltage deviation prediction unit 305 may predict a polarization voltage deviation tolerance for the battery at a specific time point based on the parameter value at the specific time point and the equivalent model circuit that processes the parameter value as an input value.

In an embodiment, the polarization voltage deviation prediction unit 305 may determine a difference value obtained by subtracting the OCV value at the specific time point from the CCV value at the specific time point as the polarization voltage B at the specific time point, and determine the maximum polarization voltage and the minimum polarization voltage by applying the preset polarization voltage deviation to the polarization voltage B.

For example, in a state where the polarization voltage deviation is set to be a negative (-) value, the polarization voltage deviation prediction unit 305 may determine the acquired polarization voltage as the maximum polarization voltage value, and determine a value obtained by applying the negative (-) polarization voltage deviation value to the acquired polarization voltage as the minimum polarization voltage value.

As another example, in a state where the polarization voltage deviation is set to be a positive (+) value, the polarization voltage deviation prediction unit 305 may determine a value obtained by applying the positive (+) polarization voltage deviation value to the acquired polarization voltage as the maximum polarization voltage value, and determine the acquired polarization voltage as the minimum polarization voltage value.

As another example, in a state where the polarization voltage deviation is set to be a range for positive (+) value and negative (-) value, the polarization voltage deviation prediction unit 305 may determine a value obtained by applying the positive (+) polarization voltage deviation value to the acquired polarization voltage as the maximum polarization voltage value, and determine a value obtained by applying the negative (-) polarization voltage deviation value to the acquired polarization voltage as the minimum polarization voltage value.

In another embodiment, the polarization voltage deviation prediction unit 305 may determine a value obtained by subtracting the maximum OCV value at the specific time point from the CCV value acquired at the specific time point as the maximum polarization voltage value, and determine a value obtained by subtracting the minimum OCV value at the specific time point from the CCV value acquired at the specific time point as the minimum polarization voltage value.

In an embodiment, the polarization voltage deviation prediction unit 305 may determine the polarization voltage deviation tolerance as a difference in value between the maximum polarization voltage and the minimum polarization voltage.

In this case, when set to apply the polarization voltage correction value based on the cumulative mileage value of the vehicle or temperature value of the battery, the device 100 may acquire a first polarization voltage correction value based on the cumulative mileage value of the vehicle, or acquire a second polarization voltage correction value based on the temperature value of the battery.

The device 100 may correct the difference value between the maximum polarization voltage value and the minimum polarization voltage value based on the acquired first polarization voltage correction value or second polarization voltage correction value, and acquire a final polarization voltage deviation tolerance. The device 100 may determine the final polarization voltage deviation tolerance as the polarization voltage deviation tolerance at the specific time point.

The measured voltage deviation measurement unit 307 may measure a measured voltage deviation (a CCV measurement deviation) for the battery at a specific time point. To describe in more detail, the measured voltage deviation measurement unit 307 may measure CCV values of a plurality of cells included in the battery at a specific time point and acquire the measured voltage deviation based on the measured CCV value.

The measured voltage deviation measurement unit 307 may measure CCV values for the plurality of cells included in the battery at a specific time point, calculate a difference value between the maximum CCV value and the minimum CCV value (i.e., a difference value between maximum measured voltage value and the minimum measured voltage value) among the measured CCV values, and determine the calculation result as the measured voltage deviation at the specific time point.

In step 405, the device 100 may determine whether the battery is in a normal state or abnormal state based on a sum of the OCV deviation tolerance and the polarization voltage deviation, and the measured voltage deviation.

For example, the battery state determination unit 309 may determine the voltage deviation tolerance at the specific time point as a sum of the OCV deviation tolerance acquired at the specific time point and the polarization voltage deviation tolerance acquired at the specific time point. As described above, the battery state determination unit 309 may sum these values together to determine the voltage deviation tolerance, or may otherwise receive this value and use it to perform the further operations described below. Further it is noted that while it is described that the battery state determination unit 309 performs the operation of determining the voltage deviation tolerance in step 405, embodiments are not so limited. The operation of determining the voltage deviation tolerance may be performed before step 405, for example, in step 403.

The battery state determination unit 309 may compare the voltage deviation tolerance with the measured voltage deviation acquired at the specific time point, and if the measured voltage deviation is less than the voltage deviation tolerance, it is determined that the battery is in a normal state. If, instead, the measured voltage deviation exceeds the voltage deviation tolerance as a result of the comparison, the battery state determination unit 309 may determine that the battery is in an "abnormal state (a state where a battery abnormality has occurred)."

If it is determined that the battery is in the "abnormal state," the battery state determination unit 309 may output a notification message about the battery abnormality through a display or speaker connected to the device 100.

When the operation of step 405 has been performed, the device 100 may complete the embodiment shown in FIG. 4.

The device 100 may acquire voltage deviation tolerances and measured voltage deviations at each time specific point through the same or similar method as the operation based on FIG. 4, and accurately determine the state of the battery according to the voltage deviation tolerances, which may vary at each point in time acquired.

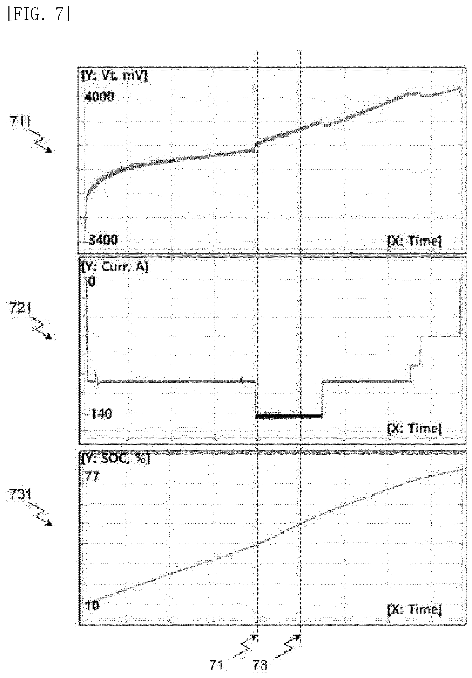

In this case, the voltage deviation tolerance, which is the reference for battery determination at the time point of determining the state of the battery by the device 100, may be set differently. Various embodiments of this case will be described in more detail with reference to FIGS. 7 to 9.

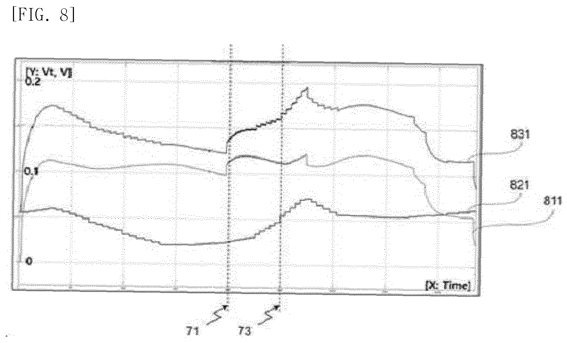

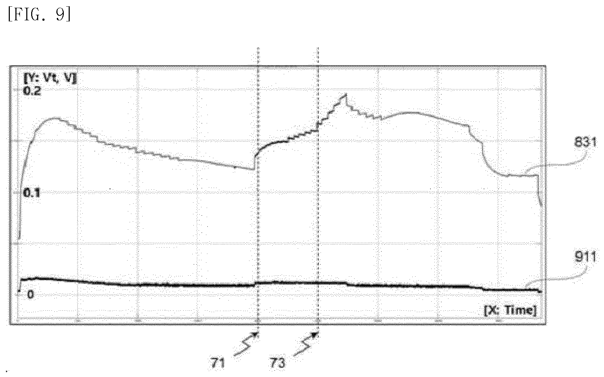

FIG. 7 a graph depicting the voltage, current, and SOC of the battery acquired at various time points in a device according to an embodiment, FIG. 8 is a graph depicting a OCV deviation tolerance, polarization voltage deviation tolerance, and voltage deviation tolerance of the battery acquired at various time points by a device according to an embodiment, and FIG. 9 is a is graph depicting a battery voltage deviation tolerance and measured voltage deviation acquired at various time points by a device according to an embodiment.

Fig. 7 shows a voltage graph 711, a current graph 721, and an SOC graph 731. As shown, for a battery of the device 100, the voltage value, the current value, and the SOC value may vary depending on the measurement time (e.g., see a first time point 71 or second time point 73).

Further, even if the same SOC value is measured at two or more time points, the voltage value or current value may vary depending on the operation state of the battery, for example, the state of charge, state of discharge, and rest state.

In addition, even if the same SOC value is measured at two or more time points, the voltage value or current value may vary depending on the time of use or frequency of use of the battery.

FIG. 8 shows an OCV deviation tolerance graph 811, a polarization voltage deviation tolerance graph 821, or a voltage deviation tolerance graph 831. As shown, the OCV deviation tolerance or polarization voltage deviation tolerance varies at each measurement time point (e.g., see the first time point 71 or the second time point 73), and therefore the voltage deviation tolerance determined based on these values also varies.

That is, the device 100 may determine the normal state or abnormal state of the battery more accurately by determining the reference value (e.g., the voltage deviation tolerance) for determining the state of the battery according to the time point of measuring the battery information.

FIG. 9 shows a voltage deviation tolerance graph 831 and a measured voltage deviation graph 911. As shown, when determining the state of the battery at the first time point 71, the device 100 may determine the normal state or abnormal state of the battery more accurately by acquiring and comparing the voltage deviation tolerance at the first time point 71 and the measured voltage deviation at the first time point 71.

Likewise, when determining the state of the battery at the second time point 73, the device 100 may determine the normal state or abnormal state of the battery more accurately by acquiring and comparing the voltage deviation tolerance at the second time point 73 and the measured voltage deviation at the second time point 73.

According to various embodiments, at least some of the graphs shown in FIGS. 7 to 9 may be results acquired by performing at least some of the operations shown in FIG. 4 by the device 100.

According to the above description, the voltage deviation tolerance, which is the reference for determining the state of the battery, is not provided as a fixed constant value, but may be provided as a variable value that can be changed with the passage of time (or the point in time of determining the state of the battery).

As described above, the device 100 may accurately set the reference for determining the state of the battery depending on the condition of the battery by acquiring the voltage deviation tolerance and the measured voltage deviation at each time point of determining the state of the battery.

According to various embodiments, the device 100 may accurately confirm the state of the battery by determining the state of the battery using the voltage deviation tolerance and the measured voltage deviation which are acquired at each time point of determining the state of the battery.

According to various embodiments, the battery circuit may be configured more simply by utilizing the existing battery circuit without additionally configuring a separate element to determine a circuit abnormality in the cell, and diagnostic efficiency in the battery operation and failure of the battery management system may be improved.

According to the detailed description above, the functions of various embodiments described as being performed by the device 100 are operations processed through the processing unit 110 of the device 100, and may be performed by organically being connected to the device 100 and/or components of the device connected to the device 100.

As described above, although the embodiments have been described with reference to the limited drawings, it will be apparent to those skilled in the art that various modifications and alternations may be applied thereto based on the various embodiments.

For example, adequate effects may be achieved even if the foregoing processes and methods are carried out in different order than those described above, and/or the above-described elements, such as systems, structures, devices, or circuits, are combined or coupled in different forms and modes than those described above, or substituted or switched with other components or equivalents.

In particular, when describing with reference to the flowchart, it has been described that a plurality of steps are configured and the steps are sequentially executed in a designated order, but it is not necessarily limited to the designated order.

In other words, executing by changing or deleting at least some of the steps described in the flowchart or adding at least one step is applicable as an embodiment, and executing one or more steps in parallel may also be applicable as an embodiment. That is, it is not limited to that the steps are necessarily operated in a time-series order, and should be included in various embodiments of the present disclosure.

## Claims

1. A device (100) for determining an abnormality in a battery (200), the device (100) comprising:
a sensing unit (140) configured to measure a voltage of the battery (200);
an information acquisition unit (301) configured to acquire battery information including a representative state of charge (SOC) value and a parameter value for an equivalent model circuit of the battery (200), at a first time point (71);
an open circuit voltage (OCV) deviation determination unit configured to acquire an OCV deviation tolerance for the battery (200) based on the representative SOC value at the first time point (71);
a polarization voltage deviation prediction unit configured to predict a polarization voltage deviation tolerance for the battery (200) based on the parameter value at the first time point (71);
a measured voltage deviation measurement unit configured to measure a measured voltage deviation for the battery (200) at the first time point (71) through the sensing unit (140); and
a battery state determination unit (309) configured to determine whether the battery (200) is abnormal based on a sum of the OCV deviation tolerance and the polarization voltage deviation tolerance, and the measured voltage deviation.

2. The device (100) according to claim 1, further comprising a storage unit (120) in which an SOC-OCV table is stored,
wherein the OCV deviation determination unit (303) is configured to acquire the OCV deviation tolerance for the battery (200) by:
acquiring a maximum OCV value and a minimum OCV value corresponding to a result obtained by applying a preset SOC deviation to the representative SOC value based on the SOC-OCV table; and
determining a difference in value between the maximum OCV value and the minimum OCV value.

3. The device (100) according to claim 1 or 2, further comprising a storage unit (120) in which the equivalent model circuit of the battery (200) is stored,
wherein the polarization voltage deviation prediction unit is configured to predict the polarization voltage tolerance for the battery (200) by:
determining a polarization voltage for the battery (200) at the first time point (71) based on the equivalent model circuit; and
applying a preset polarization voltage deviation ratio to the polarization voltage for the battery (200) at the first time point (71).

4. The device (100) according to one of claims 1 to 3, wherein the measured voltage deviation measurement unit is configured to measure the measured voltage deviation for the battery (200) by:
measuring a maximum measured voltage value and a minimum measured voltage value for the circuit (240) at the first time point (71); and
calculating a difference value between the maximum measured voltage value and the minimum measured voltage value.

5. The device (100) according to one of claims 1 to 4, wherein the battery state determination unit (309) is configured to determine whether the battery (200) is abnormal by:
determining a voltage deviation tolerance at the first time as a sum of the OCV deviation tolerance at the first time point (71) and the polarization voltage deviation tolerance at the first time point (71); and
determining whether the measured voltage deviation exceeds the voltage deviation tolerance.

6. The device (100) according to one of claims 1 to 5, further comprising a storage unit (120) in which a cumulative mileage of a vehicle including the battery (200) is stored,
wherein the OCV deviation determination unit (303) is configured to acquire the OCV deviation tolerance based on the cumulative mileage value of the vehicle at the first time point (71) acquired from the storage unit (120) and the representative SOC value at the first time point (71).

7. The device (100) according to one of claims 1 to 6, further comprising a storage unit (120) in which a cumulative mileage of a vehicle including the battery (200) is stored,
wherein the sensing unit (140) is configured to measure a temperature of the battery (200), and
the polarization voltage deviation prediction unit is configured to determine the polarization voltage deviation tolerance based on two or more of: the cumulative mileage value of the vehicle at the first time point (71) acquired from the storage unit (120), a temperature value of the battery (200) measured at the first time point (71), and the parameter value at the first time point (71).

8. A method for determining an abnormality in a battery (200), the method comprising:
acquiring battery information including a representative state of charge (SOC) value of the battery (200) and a parameter value for an equivalent model circuit of the battery (200), at a first time point (71);
acquiring an OCV deviation tolerance for the battery (200) based on the battery information;
predicting a polarization voltage deviation based on the battery information;
measuring a measured voltage deviation, at the first time point (71), based on the battery information; and
determining whether the battery (200) is abnormal based on a sum of the OCV deviation tolerance and the polarization voltage deviation, and the measured voltage deviation.

9. The method according to claim 8, wherein the acquiring the OCV deviation tolerance comprises:
acquiring a maximum OCV value and a minimum OCV value corresponding to a result obtained by applying a preset SOC deviation to the representative SOC value based on an SOC-OCV table; and
determining a difference in value between the maximum OCV value and the minimum OCV value.

10. The method according to claim 8 or 9, wherein the predicting the polarization voltage deviation comprises:
determining a polarization voltage for the battery (200) at the first time point (71) based on the equivalent model circuit to which the parameter value is applied; and
applying a preset polarization voltage deviation ratio to the polarization voltage for the battery (200) at the first time point (71).

11. The method according to one of claims 8 to 10, wherein the measuring the measured voltage deviation comprises:
measuring a maximum measured voltage value and a minimum measured voltage value for the circuit (240) at the first time point (71); and
calculating a difference in value between the maximum measured voltage value and the minimum measured voltage value.

12. The method according to one of claims 8 to 11, wherein the determining whether the battery (200) is abnormal comprises:
determining a a voltage deviation tolerance at the first time point (71) as sum of the OCV deviation tolerance at the first time point (71) and the polarization voltage deviation tolerance at the first time point (71); and
determining whether the measured voltage deviation exceeds the voltage deviation tolerance.

13. The method according to one of claims 8 to 12, wherein the acquiring the OCV deviation tolerance comprises acquiring the OCV deviation tolerance based on a cumulative mileage value acquired from a vehicle including the battery (200) and the representative SOC value at the first time point (71).

14. The method according to one of claims 8 to 13, wherein the predicting the polarization voltage deviation comprises determining the polarization voltage deviation tolerance based on two or more of: a cumulative mileage value acquired from a vehicle including the battery (200) at the first time point (71), a temperature value of the battery (200) measured at the first time point (71), and the parameter value at the first time point (71).

15. A processor comprising:
an information acquisition unit (301) configured to acquire battery information of a battery (200) including a representative state of charge (SOC) value and a parameter value for an equivalent model circuit of the battery (200), at a first time point (71);
an open circuit voltage (OCV) deviation determination unit configured to acquire an OCV deviation tolerance for the battery (200) based on the representative SOC value at the first time point (71);
a polarization voltage deviation prediction unit configured to predict a polarization voltage deviation tolerance for the battery (200) based on the parameter value at the first time point (71);
a measured voltage deviation measurement unit configured to measure a measured voltage deviation for the battery (200) at the first time point (71) through the sensing unit (140); and
a battery state determination unit (309) configured to determine whether the battery (200) is abnormal based on a sum of the OCV deviation tolerance and the polarization voltage deviation tolerance, and the measured voltage deviation.
